**Europäisches Patentamt**

(19) **European Patent Office**

**Office européen des brevets**

(11) Publication number: **0 013 352**
**B1**

(12) EUROPEAN PATENT SPECIFICATION

(45) Date of publication of patent specification: 09.02.83

(21) Application number: 79104978.6

(22) Date of filing: 06.12.79

(51) Int. Cl.³: **H 05 K 1/02, H 01 G 4/32, H 02 M 7/06**

(54) Feeding device for printed circuit board and feeding element.

(30) Priority: 22.12.78 JP 159437/78
22.12.78 JP 159438/78

(43) Date of publication of application:
23.07.80 Bulletin 80/15

(45) Publication of the grant of the patent:
09.02.83 Bulletin 83/6

(84) Designated Contracting States:
DE FR GB NL SE

(56) References cited:
DE - A - 2 229 293
DE - A - 2 820 232
FR - A - 2 394 161
US - A - 2 470 826

HÖNGER et al. "Rundfunk-Röhren,
Eigenschaften und Anwendung von
Fernsehröhren", 1957, REGELIEN'S VERLAG,
Berlin-Grunewald

(73) Proprietor: Jelmax Co., Ltd
Rm. 1005 DIK Bldg 5-4, Shinbashi 6 Chome
Minato-ku Tokyo (JP)

(72) Inventor: Hideo, Kurose
11-45, Kotsubo 7 Chome
Zushi-shi Kanagawa-ken (JP)

(74) Representative: Eitle, Werner, Dipl.-Ing. Dipl.-Ing.
Werner Eitle Dr. rer. nat. Klaus Hoffmann et al,
Dipl.-Ing. Werner Lehn Dipl.-Ing. Klaus Füchsle
Dr. rer. nat. Bernd Hansen Arabellastrasse 4
D-8000 München 81 (DE)

Courier Press, Leamington Spa, England

Feeding device for printed circuit board and feeding element

This invention relates to a feeding device for a printed circuit board useful particularly for high fidelity, low noise amplifier etc., and also relates to a novel feeding element used therein.

A conventional printed circuit board comprises a wiring circuit of stringy-made foil which is prepared by placing a copper foil on an insulating board and etching the so laminated copper foil. Generally, the thickness of the copper foil is relatively so thin as several tens to several hundreds micronmeters. When the thinner foil is employed for a printed circuit board, however, there occurs non-linear distortion on the printed circuit that employs the so treated foil as line. For this reason, a printed circuit used in a high-quality audio equipments comprises, for example, sufficiently thicker foil to avoid the non-linear distortion. The employment of such thicker foil, however, requires very long time for the etching, in other words, for forming the circuit. This inevitably results in the circuit of extremely high price. There also is another principal non-linear distortion disturbing the amplifier, occurring on another portion than the above-mentioned circuit. That is a power source being connected to the circuit, and it is ascertained that the non-linear distortion occurring in an electrolytic condenser provided to the power source particularly causes cross modulation on either of signals, resulting in lowering extremely the quality of the amplifier.

For another example, in digital signal devices such as computers, the power feeding line on the printed circuit board is supplied with deposited feeding bus bars having distributed capacities. In this case, the distributed capacity per unit length of the bus bar is as extremely little as 500 PF/100 mm at the maximum. This means that enough by-pass function cannot be achieved when such system is employed in the audio band. In addition, since this system utilizes such material of high dielectric constant as film of plastic material, ceramic material, etc., as the dielectric material providing the distributed capacity, the non-linear distortion of the line increases due to the dissipation factor of the material and enhances equivalent series resistance to enlarge the internal loss. These phenomena result in increase of the distortion among the circuits utilizing the common power line. Therefore, such bus bar cannot be employed in a high-quality audio equipment.

This invention, accordingly, provides a feeding device for the printed circuit board useful particularly for such low-noise electric equipments as high quality audio and video equipments, and a feeding element used therein, both of which comprises providing an improved feeding means to a portion constituting a common power line in plural circuits on a printed circuit board and also providing a novel feeding element of large capacity and low loss pertinent to the feeding means, thereby decreasing as far as possible the non-linear distortion occurring in the power source.

From the US—A—2 470 826 an electrical capacitor of the metallized type is known in which a thin flexible sheet of dielectric material is provided with individual electrode coatings applied to both sides thereof by metallization. The coated dielectric is then folded along the centre line before rolling; the sheet may be however folded any odd number of times before rolling. A number of terminal tabs are provided, which engage an electrode 12 and a number of similar terminal tabs are also provided which engage an electrode coating 13.

It is a principal object of this invention to provide a feeding device and a feeding element that are able to minimize the non-linear distortion occurring on a power line in an electric device utilizing a printed circuit board.

It is another object of this invention to decrease cross modulation occurring among the circuits using a common line in an electric device utilizing a printed circuit board, by constituting the power line on the printed circuit board with distributed capacity elements of low loss.

It is still another object of this invention to provide a feeding element of low loss and large distributed capacity that is able to minimize the distortion occurring among the circuits using a common power line in an electric device utilizing a printed circuit board.

According to this invention, there is provided a feeding device for a printed circuit board which comprises in combination:
— a low-loss laminated distributed capacity element which has a first and a second conductive strip separated by a low-loss dielectric layer folded and coiled up so as to form a plural number of layers and having leading-out terminals provided to said first and second conductive strips, said second conductive strip being connected to an earthing circuit;
— a power source connected to at least one leading-out terminal of said first conductive strip;
— an electrolytic condensor connected to said power source;
— at least one non-polarized condenser having a dissipation factor being intermediate between that of said distributed capacity element and that of said electrolytic condenser connected in parallel with said electrolytic condenser.

There is also provided a feeding element in a feeding device for a printed circuit board which is characterized in that a distributed capacity element so formed in a substantially oblong shape by folding and coiling up a plural number of layers consisting at least of the first conductive strip placed on a dielectric layer and the second conductive strip placed on another dielectric layer each laminated alternately that the first conductive strip and the second conductive strip are separated from each other by the respective dielectric layers and that the length in the longitudinal direction of the distributed capacity element is sufficiently greater than the width of the conductive strips, that a plural number of terminals is led out of one side of the distributed capacity element at appropriated intervals and connected to each of the strips, that means for connecting in common each couple of the terminals which belongs to the same strip and are located adjacent to each other among said terminals is provided, and that a container encloses the distributed capacity element.

Further features of the invention appear from the dependent claims.

An embodiment of this invention is explained below with reference to the accompanying drawings, in which:

Fig. 1 is a circuit diagram showing a feeding device embodying this invention;

Fig. 2 is a main portion of a feeding element used in a feeding device of this invention, in which (A) is a perspective view, and (B) is a cross-sectional view taken along the line X—X of (A) and slightly enlarged in thickness;

Fig. 3 is a perspective view showing a container forming a shell of a feeding element of this invention; and

Fig. 4 is a perspective view showing a completed feeding element.

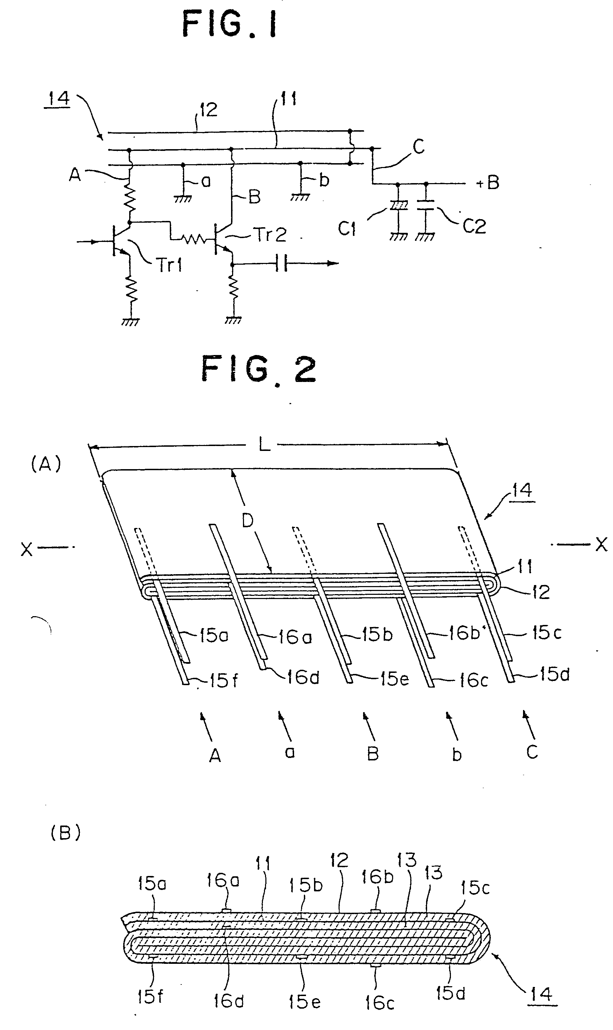

In Fig. 1, numerals 11 and 12 respectively designate the first and second strips, having high electro-conductivity, made of copper foil or the like, and the first and second strips, 11 and 12, are separated from each other by a dielectric layer having a dissipation factor of not more than 0.1% at 100 KHz, and made of dielectric material such as polystyrene resin, fluororesin and polypropylene resin, and a plural number of the so layered strips is folded and coiled up to form a distributed capacity element 14 of the laminated layers having an electrostatic capacity of not less than 5000 PF/100 mm in length.

On the first strip 11 of the distributed capacity element 14 are provided a plural number of leading-out terminals A, B and C, and the terminals A and B are, for instance, connected to collector terminals of the transistors $Tr_1$ and $Tr_2$ constituting an audio amplifier circuit to serve as feeding terminals for the same. The leading-out terminal C is connected to a power source circuit (not shown) to supply +B power source. To the terminal C is connected an electrolytic condenser $C_1$ having relatively large capacity to smooth the power current and to serve as a common path for signals.

An electrolytic condenser $C_1$ is, generally, non-linear to the signal frequency and, particularly in the high audible frequency band to which the audio signal belongs, the internal loss causing the non-linearity is so great as to provide distortion to the supplied audio signal, resulting in causing cross modulation and disturbing extremely the fidelity of regenerative audio signal. For settling such problems residing in sole use of the electrolytic condenser $C_1$, the aforementioned low loss distributed capacity element 14 of this invention utilizes a dielectric layer of the above-mentioned material and is a laminated one comprising a number of conductive strips and having such relatively great capacity as not less than 5000 PF/100 mm in length, and therefore the element 14 has extremely low internal loss in the range up to such frequency band as higher than the high signal frequency area in the audible frequency band, and low non-linear characteristic to inhibit the occurrence of the distortion. Accordingly, the distortion in the high frequency band decreases.

As for the distortion in the middle audio frequency band, if a non-polarized condenser $C_2$ of polyester film, paper or polycarbonate film, having such large capacity as 1 to 10 $\mu$F, though its dissipation factor is slightly larger than that of the dielectric layer of the distributed capacity element 14, and smaller than that of the electrolytic condenser $C_1$ is connected in parallel and selected so as to improve the non-linear characteristic caused in the middle frequency band by the aforementioned electrolytic condenser $C_1$ and to reduce almost continuously the loss from a low frequency area towards a high frequency area of the whole audible frequency band, the cross modulation distortion occurring in the power source and the common line can be avoided very efficiently and the regeneration is carried out very effectively with high fidelity throughout the audio signal band.

Moreover, since the condensers $C_1$ and $C_2$, both connected to the feeding terminal C, and the leading-out terminals A and B are also connected to the distributed capacity element having the conductive strip 11, E.S.R. (Equivalent Series Resistance) of each of the condensers $C_1$ and $C_2$ viewed from each leading-out terminal of the line towards the power source is prominently smaller than the E.S.R. of the condensers viewed from narrowly formed feeding point towards the concentratedly constituted power source in a conventional printed circuit board. For this reason, the internal loss of the power source of each circuit is prominently reduced, and undesirable influences on the amplifying signal caused by the loss present in the power source side is also reduced to provide the high fidelity regeneration.

In addition, other condensers than the condenser $C_2$, such as those having different loss and capacity may be provided to the system.

If a plural number of leading-out terminals $a$ and $b$ are optionally provided to the second strip 12 of the aforementioned distributed capacity element 14 and then the terminals $a$ and $b$ are earthed, the resulting effect is better than that obtained when only a single terminal is earthed.

Fig. 2 shows the structure of a feeding element according to this invention. The first conductive strip 11 of narrow shaped copper foil having a thickness of 5 to 30 $\mu$m, a dielectric layer of a low loss film 13 made of polystyrene resin, fluororesin, polypropylene resin or the like and having a dissipation factor of not more than 0.1% at 100 KHz and a thickness of 6 to 20 $\mu$m, the second conductive strip 12 having the same property as in the strip 11, another dielectric layer of a low loss film 13′ having the same characteristics as in the layer 13 are alternately laminated in this order, and a plural number of the so layered strips is folded and coiled up to form a distributed capacity element 14 having an electrostatic capacity between the first and second strips of not less than 5000 PF/100 mm in length. The distributed capacity element 14 is so folded and coiled up that the first conductive strip 11 and the second conductive strip 12 are separated from each other by the respective dielectric layers 13 and 13′, and that the element 14 is in a substantially oblong shape whose longer side has the length L sufficiently greater than the width D (shorter side) of the strips 11 and 12 as shown in (A) of Fig. 2. The length L, more particularly, should preferably be about 3 to 10 times greater than the width D.

If necessary, to the so layered strips as mentioned above may be further laminated and coiled up together, the third conductive strip, the fourth conductive strip and so on each having the same dielectric layer as mentioned above.

On each of the strips 11 and 12 are provided a plural number of terminals 15a, 15b, ... and 16a, 16b, ..., respectively, ·at appropriate intervals, along the longitudinal direction thereof and led outwardly in the direction substantially rectangular against the one side line of the aforementioned coiled distributed capacity element 14.

Each couple of the leading-out terminals of either the first or second strips 11 or 12, being located adjacent to each other, namely, each couple of the terminals 15a and 15f, terminals 15b and 15e, terminals 15c and 15d, terminals 16a and 16d, and terminals 16b and 16c is connected in common. This means that the strips 11 and 12 are connected, along the longitudinal directions, through the so formed short circuit, and that the leading-out terminals A, B and C and the leading-out terminals $a$ and $b$ are provided corresponding to the first strip 11 and the second strip 12, respectively.

In this case, as shown in Fig. 2, the terminals 15a, 15b, ..., 16a, 16b, ... can be in the form of foil and fixed to the strips 11 and 12, and then the strips with the fixed terminals ar coiled up. Alternatively, the terminals can b formed integrally in such a manner that th terminals protrudes from the sides of the strip 11 and 12.

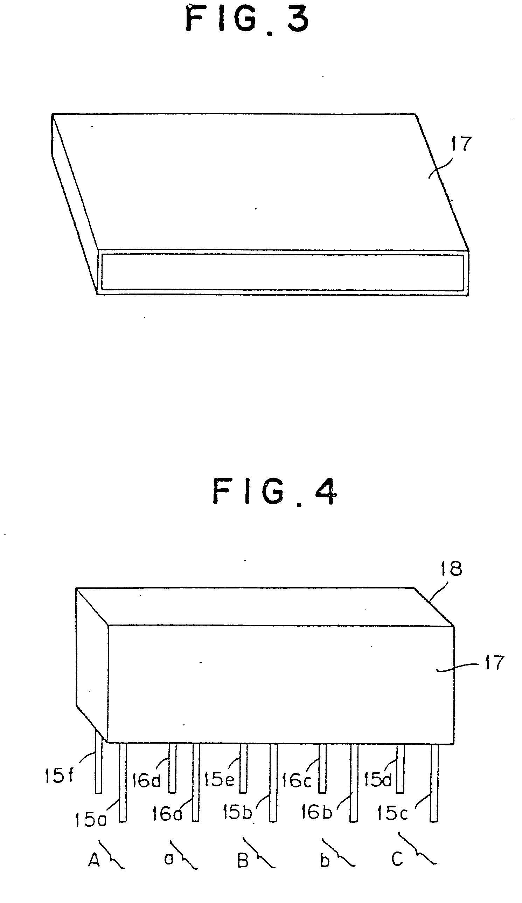

The distributed capacity element 14 thu formed in the flat shape can be placed within container 17 made of plastic material, as show in Fig. 3, and fixed therein with an appropria filler. Alternatively, the element 14 can t simply enveloped in a protective film such as film of plastic material or rubber.

Fig. 4 is a perspective view showing th completed feeding element 18 for a printe circuit board. In this Figure, the terminals 15 15b, ..., 16a, 16b, ..., are illustrated in such manner that the terminals are led out separate and independently. In another embodiment, tl terminals can be connected therebetwe within the container 17 and fixed and protect in the container with a filler, as describ hereinbefore. If the element as illustrated in F 4 is employed for a printed circuit board, t terminals are jointly connected to the circ elements in an appropriate way. In the embo ment as shown in Fig. 4, the container 17 separately and independently prepared for t application: In an alternative example, if the d tributed capacity element 14 is immersed melted plastic material to become coated a encapsulated therein, the encapsulation th prepared can serve as the container 17 protect and fix effectively the leading-( terminals with solidified plastic material.

Since the leading-out terminals $a$ and $b$ the distributed capacity element 14 are earth as shown in Fig. 1, the common power sou for each of circuits of the transistors $Tr_1$ and becomes having low loss and earthed soli due to the distributed electrostatic capac formed between the strips 11 and Accordingly, the circuit can work stably v only extremely low level of distorted nois Moreover, coupling between the circuits can occur. In this case, if the coiled first and sec strips 11 and 12 on the outer side viewed in coiled state are made to form the earth circuits and the strips on the inner side are u for a power source, the power source is ef tively shielded from other circuits.

The incorporation of one feeding element cannot be expected to safisfy a number of transistor elements, because the feec element 18 inevitably carries only a lim number of leading-out terminals for feedinc this occasion, a plural number of the feec elements 18 can be employed in accorda with the number of the feeding terminals. leading-out terminals for feeding (the lead out terminals for positive pole in the exampli each feeding element 18 can be directly conne to those terminals of other feeding elements lead-in wires. Otherwise, those terminals are nected to each other in the cascade connec employing appropriate resistance on connecting wires. Further, condensers corresponding to the condensers $C_1$ and $C_2$ are, if necessary, connected to the feeding elements 18. By setting out the elements and parts in the above manner, the feeding can be effectively done to a whole system of the circuits and the high-fidelity amplifier works more excellently.

Since each of the first and second strips constituting the feeding element carries a plural number of the terminals led out therefrom and the terminals form the short circuits, as described hereinbefore, there occurs no resonance at a certain frequency band, which is liable to be caused by the distributed capacity of the feeding element and the inductance occurring due to the coiled strips and thus the circuits cannot become unstable. Moreover, since the resonance of the condensers $C_1$ and $C_2$ connected in parallel is effectively suppressed by the feeding element based on the above-stated reason, the whole feeding system works very stably. Resonances never occur throughout the wide frequency band and the system works more stably than a power source system in which a plural number of condensers are provided in a concentrated manner to an electrolytic condenser.

Accordingly, this invention provides a feeding device and a feeding element readily fitted to the conventional printed circuit, with no considerable change of the structure of the circuit, that is incorporated in a feeding device for equipments which handles weak analog signals, for example, an audio amplifier, a video equipment, etc.

Shortly summarized the invention comprises a feeding device for a printed circuit board useful particularly for high fidelity and low noise amplifier etc., and a feeding element used therein, wherein the feeding device comprises a distributed capacity element 14 consisting at least of a first conductive strip 11 and the second conductive strip 12 separated from each other by a low-loss dielectric layer, leading-out terminals A, B, C provided to said first conductive strip 11, a power source connected to at least one leading-out terminal C of the same, an electrolytic condenser $C_1$ connected to the power source, and at least one non-polarized condenser $C_2$ connected to the electrolytic condenser $C_1$ in parallel, said second conductive strip 12 being connected to an earthing circuit; and the feeding element comprises the distributed capacity element 14 formed in an oblong shape by folding and coiling up the first and the second conductive strip 11, 12 layered as in the above-mentioned, and leading-out terminals connected to each of the strips 11, 12, said element is enclosed in a container our encapsulated by plastic material.

## Claims

1. A feeding device for a printed circuit board, characterized in that it comprises in combination:
— a low-loss laminated distributed capacity element (14) which has a first (11) and a second (12) conductive strip separated by a low-loss dielectric layer (13) folded and coiled up so as to form a plural number of layers and having leading-out terminals (15, 16) provided to said first and second conductive strips, said second conductive strip (12) being connected to an earthing circuit;
— a power source (+B) connected to at least one leading-out terminal (15) of said first conductive strip (11);
— an electrolytic condenser $(C_1)$ connected to said power source;
— at least one non-polarized condenser $(C_2)$ having a dissipation factor being intermediate between that of said distributed capacity element (14) and that of said electrolytic condenser $(C_4)$ connected in parallel with said electrolytic condenser.

2. A feeding device for a printed circuit board as claimed in claim 1, characterized in that the material of the low-loss dielectric layer (13) is selected from the group consisting of polystyrene resin, fluororesin and polypropylene resin and the electrostatic capacity of the distributed capacity element (14) is not less than 5000 PF/100 mm in length.

3. A feeding device for a printed circuit board as claimed in claim 1, characterized in that the non-polarized condenser $(C_2)$ is made of polyester film, paper or polycarbonate film.

4. A feeding element in a feeding device for a printed circuit board as claimed in claim 1, characterized in that a distributed capacity element (14) is so formed in a substantially oblong shape by folding and coiling up a plural number of layers consisting at least of the first conductive strip (11) placed on a dielectric layer (13) and the second conductive strip (12) placed on another dielectric layer (13') each laminated alternately that the first conductive strip (11) and the second conductive strip (12) are separated from each other by the respective dielectric layers (13, 13') and that the length (L) in the longitudinal direction of the distributed capacity element (14) is sufficiently greater than the width (D) of the conductive strips (11, 12), that a plural number of terminals (15, 16) is led out of one side of the distributed capacity element (14) at appropriated intervals and connected to each of the strips (11, 12), that means for connecting in common each couple of the terminals which belongs to the same strip and are located adjacent to each other among said terminals is provided, and that a container (17) encloses the distributed capacity element.

5. A feeding element for a printed circuit board as claimed in claim 4, characterized in that the outer sides of the coiled first and second strips (11, 12) are earthed and the inner sides thereof are employed for power feeding.

6. A feeding element for a printed circuit board as claimed in claim 4, characterized in that the material of the low-loss dielectric layer (13) has a dissipation factor of not more than 0.1% at 100 KHz.

7. A feeding element for a printed circuit board as claimed in claim 4, characterized in that a plural number of the leading-out terminals are connected therebetween in cascade connection directly or via resistance.

8. A feeding element for a printed circuit board as claimed in claim 4, characterized in that the container (17) is formed by immersing the distributed capacity element (14) in melted plastic material.

9. A feeding element for a printed circuit board as claimed in claim 4, characterized in that the length (L) of the distributed capacity element (14) prepared by folding and coiling the first and second strips (11, 12) up is about 3 to 10 times greater than the width (D) of the strips (11, 12).

## Patentansprüche

1. Stromversorgungsanordnung für eine gedruckte Schaltung, dadurch gekennzeichnet, daß sie in Kombination aufweist:

— ein laminiertes verteiltes Kapazitätselement (14) niedriger Verluste, welches einen ersten (11) und eine zweiten (12), durch eine dielektrische Schicht (13) niedriger Verluste getrennten leitenden Streifen, zur Ausbildung einer Mehrzahl von Lagen gefaltet und aufgewickelt, aufweist, wobei herausführende Anschlüsse (15, 16) an den ersten und zweiten leitenden Streifen vorgesehen sind und der zweite leitende Streifen (12) mit einem Erdungskreis verbunden ist;

— eine mit wenigstens einem herausführenden Anschluß (15) des ersten leitenden Streifens (11) ·verbundene Energiequelle (+B);

— einen mit der Energiequelle verbundenen Elektrolytkondensator ($C_1$);

— wenigstens einen nicht .polarisierten Kondensator ($C_2$) mit einem Verlustfaktor zwischen dem des verteilten Kapazitätselements (14) und dem des Elektrolytkondensators ($C_4$), welcher parallel zu dem Elektrolytkondensator geschaltet ist.

2. Stromversorgungsanordnung für eine gedruckte Schaltung nach Anspruch 1, dadurch gekennzeichnet, daß das Material der dielektrischen Schicht (13) niedriger Verluste aus der Gruppe bestehend aus Polysterolharz, Fluorharz und Polypropylenharz ausgewählt ist und die elektrostatische Kapazität des verteilten Kapazitätselements (14) nicht weniger als 5000 PF/100 mm Länge ist.

3. Stromversorgungsanordnung für eine gedruckte Schaltung nach Anspruch 1, dadurch gekennzeichnet, daß der nicht polarisierte Kondensator ($C_2$) aus Polyesterfilm, Papier oder Polycarbonatfilm hergestellt ist.

4. Einzelteil für die Stromversorgung in einer Stromversorgungsanordnung für eine gedruckte Schaltung nach Anspruch 1, dadurch gekennzeichnet, daß das verteilte Kapazitätseleme derart in einer im wesentlichen langgestreckt Form durch Falten und Aufwickeln ein Mehrzahl von Lagen bestehend aus wenigste dem ersten leitenden Streifen (11) auf ein dielektrischen Schicht (13) und dem zweiten le tenden Streifen (12) auf einer weiteren diele trischen Schicht (13') jeweils alternat geschichtet ausgebildet ist, daß der erste leite de Streifen (11) und der zweite leitende Streife (12) voneinander durch die entsprechende dielektrischen Schichten (13, 13') getrennt sir und die Länge (L) in Längsrichtung des ve teilten Kapazitätselements (14) genüger größer als die Breite (D) der leitenden Streife (11, 12) ist, daß eine Mehrzahl von Anschlüsse (15, 16) auf einer Seite des verteilte Kapazitätselements in geeigneten Intervalle herausgeführt und mit jedem der Streifen (1' 12) verbunden ist, daß Einrichtungen zur gemeinsamen Verbinden jedes Paares de Anschlüsse, welche zu dem gleichen Streife gehören und benachbart zueinander ange ordnet sind, zwischen den Anschlüssen vorge sehen sind, und daß ein Behälter (17) das ve teilte Kapazitätselement umschließt.

5. Einzelteil für due Stromversorgung für ein gedruckte Schaltung nach Anspruch 4, dadurc gekennzeichnet, daß die äußeren Seiten de aufgewickelten ersten und zweiten Streifen (11 12) geerdet und die inneren Seiten für di Energiezufuhr verwendet sind.

6. Einzelteil für die Stromversorgung für ein gedruckte Schaltung nach Anspruch 4, dadurcl gekennzeichnet, daß das Material der dielek trischen Schicht (13) niedriger Verluste eine Verlustfaktor von nicht mehr als 0,1% bei 10( KHz hat.

7. Einzelteil für die Stromversorgung für ein gedruckte Schaltung nach Anspruch 4, dadurcl gekennzeichnet, daß eine Mehrzahl von heraus führenden Anschlüssen in Kaskade miteinande direkt oder über einen Widerstand verbunder sind.

8. Einzelteil für die Stromversorgung für ein gedruckte Schaltung nach Anspruch 4, dadurcl gekennzeichnet, daß der Behälter durch Ein tauchen des verteilten Kapazitätselements (14 in geschmolzenes Kunststoffmaterial gebilde ist.

9. Einzelteil für die Stromversorgung für eine gedruckte Schaltung nach Anspruch 4, dadurcl gekennzeichnet, daß die durch Falten und Auf wickeln der ersten und zweiten Streifen (11, 12] erreichte Länge (L) des verteilten Kapazitäts elements (14) etwa 3 bis 10 mal größer als die Breite (D) der Streifen (11, 12) ist.

## Revendications

1. Assemblage d'alimentation pour une plaquette de circuit imprimé, caractérisé en ce qu'il comporte en combinaison: un élément (14) de capacité distribuée empilé à faible perte qui comprend une première (11) et une seconde (12) bandes conductrices séparées par une couche (13) diélectrique à faible perte, pliée et enroulée de manière à former un nombre multiple de couches et comprenant des bornes de sortie (15, 16) prévues pour lesdites première et seconde bandes conductrices, ladite seconde bande conductrice (12) étant connectée à un circuit de mise à la terre, une source d'alimentation (+B) connectée à au moins une borne de sortie (15) de ladite première bande conductrice (11), un condensateur électrolytique (C₁) connecté à ladite source d'alimentation, au moins un condensateur non polarisé (C₂) ayant un facteur de dissipation intermédiaire entre celui dudit élément (14) d'élément de capacité distribuée et celui dudit condensateur électrolytique (C₁) connecté en parallèle avec ledit condensateur électrolytique.

2. Assemblage d'alimentation pour une plaquette de circuit imprimé selon la revendication 1, caractérisé en ce que la matière de la couche diélectrique (13) à faible perte est choisie dans le groupe comprenant une résine de polystyrène, une fluororésine et une résine de polypropylène, et la capacité électrostatique de l'élément de capacité distribuée (14) n'est pas inférieure à 5000 pF/100 mm de longueur.

3. Assemblage d'alimentation pour une plaquette de circuit imprimé selon la revendication 1, caractérisé en ce que le condensateur (C₂) non polarisé est fait d'un film de polyesther, de papier ou d'un film de polycarbonate.

4. Elément d'alimentation dans un assemblage d'alimentation pour une plaquette de circuit imprimé selon la revendication 1, caractérisé en ce qu'un élément de capacité distribuée (14) est formé en une forme pratiquement oblongue en pliant et en enroulant un nombre multiple de couches consistant en au moins la première bande conductrice (11) placée sur une couche diélectrique (13) et la seconde bande conductrice (12) placée sur une autre couche diélectrique (13'), superposées alternativement chacune, en ce que la première bande conductrice (11) et la seconde bande conductrice (12) sont séparées l'une de l'autre par les couches diélectriques respectives (13, 13') et en ce que la longueur (L) dans la direction longitudinale de l'élément de capacité distribuée (14) est suffisamment supérieure à la largeur (D) des bandes conductrices (11, 12), en ce que un nombre multiple de bornes (15, 16) sont sorties d'un côté de l'élément de capacité distribuée (14) à des intervalles appropriés et connectées à chacune des bandes (11, 12), en ce qu'un dispositif pour connecter en commun chaque paire de bornes qui appartiennent à la même bande et qui sont disposées l'une près de l'autre parmi lesdites bornes est prévu, et en ce qu'un boîtier (17) enferme l'élément de capacité distribuée.

5. Elément d'alimentation pour une plaquette de circuit imprimé selon la revendication 4, caractérisé en ce que les côtés extérieurs des première et seconde bandes (11, 12) sont connectées à la terre et que les côtés intérieurs sont utilisés pour la fourniture d'alimentation.

6. Elément d'alimentation pour une plaquette de circuit imprimé selon la revendication 4, caractérisé en ce que la matière de la couche diélectrique (13) à faible perte a un facteur de dissipation qui n'est pas supérieur à 0,1 pour cent à 100 kHz.

7. Elément d'alimentation pour une plaquette de circuit imprimé selon la revendication 4, caractérisé en ce qu'un nombre multiple de bornes de sortie sont connectées entre elles en connexion en cascade, directement ou par une résistance.

8. Elément d'alimentation pour une plaquette de circuit imprimé selon la revendication 4, caractérisé en ce que le boîtier (17) est formé en plongeant l'élément de capacité distribuée (14) dans de la matière plastique fondue.

9. Elément d'alimentation pour une plaquette de circuit imprimé selon la revendication 4, caractérisé en ce que la longueur (L) de l'élément de capacité distribuée (14) préparé en pliant et en enroulant les première et second bandes (11, 12) est environ trois à dix fois plus grande que la largeur (D) des bandes (11, 12).

0 013 352

# FIG. 1

# FIG. 2

(A)

(B)

1

0013352

## FIG.3

## FIG.4